# EUROPEAN PATENT APPLICATION

(11) **EP 4 597 594 A1**
(43) Date of publication of application: **06.08.2025**
(21) Application number: 24164478.0
(22) Date of filing: 19.03.2024
(51) Int. Cl.: H01M 4/04, H01M 10/04, B26D 5/00

(54) **SYSTEM AND METHOD FOR MANUFACTURING AN ELECTROD ASSEMBLY FOR A BATTERY**

(30) Priority: 01.02.2024 KR 20240016070
(71) Applicant: LG Energy Solution, Ltd., Seoul 07335 (KR)
(72) Inventor: SIM, Min Kyu, 34122 Daejeon (KR); KIM, Min Su, 34122 Daejeon (KR); PARK, Jong Seok, 34122 Daejeon (KR); LEE, Dong Yeop, 34122 Daejeon (KR); KANG, Kyu Taek, 34122 Daejeon (KR); KOH, Jee Yeon, 34122 Daejeon (KR); KANG, Ju Ye, 34122 Daejeon (KR)
(74) Representative: BCKIP Part mbB

(57) **Abstract**

A system and a method for manufacturing an electrode assembly for a battery are provided. The system includes a first cutter configured to cut a first patterned electrode sheet to form a first electrode cut portion having a first length, a first sensor arrangement configured to generate a first cutting operation code and to acquire first position data reflecting positions on the first electrode sheet, a second cutter configured to cut a second patterned electrode sheet to form a second electrode cut portion having a second length, a second sensor arrangement configured to generate a second cutting operation code and to acquire second position data, a combinator configured to manufacture an electrode assembly by combining the first electrode cut portion and the second electrode cut portion with a separator interposed therebetween, and an identification information assigning device configured to assign identification information to the manufactured electrode assembly and associate the identification information with the first cutting operation code and the first position data, and with the second cutting operation code and the second position data.

## Description

### [Technical Field of the Invention]

The present invention relates to a system and a method for manufacturing an electrode assembly for a battery.

### [Background of the Invention]

Unlike primary batteries, secondary batteries can be charged or discharged a plurality of times. The secondary batteries are widely used as energy sources for various wireless devices such as handsets, notebook computers, cordless vacuum cleaners, and the like. Recently, the manufacturing cost per unit capacity of a secondary battery has been significantly reduced due to improvements in energy density and economies of scale, and as the traveling distance of a battery electric vehicle (BEV) increases to the same level as that of a fuel vehicle, the main use of secondary battery is shifting from a mobile device to mobility.

A secondary battery is manufactured through an electrode process, an assembly process, and an activation process. Among the above processes, the electrode process is the most critical process in determining the yield and performance of battery cells. The electrode process may include a coating process, a roll pressing process, and a slitting process. In the coating process, a surface of a current collector. In the roll pressing process may be coated with an active material and an insulating material, an electrode may be pressed by pressing rolls. The roll pressing process may determine the density, performance, and surface quality of the electrode. In the slitting process, the electrode may be cut into a plurality of electrodes depending on the battery cell design.

Korean Laid-open Patent Publication No. 10-2022-0134303 describes a method for monitoring a coating process of an electrode sheet, wherein an electrode sheet is continuously coated with slurry, and data related to quality or defects are measured in the electrode coating process. The measured data is visually displayed at a certain position on a roll map bar corresponding to the position of the electrode at which the pieces of data are measured. The roll map bar is a visual imitation of the electrode sheet moving in the coating process.

### [Summary of the Invention]

It is an object of the present invention to provide a with a solution that enables improved quality traceability and data match in a battery manufacturing process, particularly involving patterned electrodes.

To this end, the present invention provides a system in accordance with claim 1 and a method in accordance with claim 13.

According to one aspect of the present invention, a system for manufacturing an electrode assembly for a battery in provided. The method may comprise at least one of: a first cutter configured to cut a first electrode sheet to form a first electrode cut portion having a first length, the first electrode sheet including a plurality of first coating patterns, each coating pattern having at least one coated and one uncoated portion; a first sensor arrangement configured to generate a first cutting operation code identifying the operation of the first cutter to form a respective first electrode cut portion, and to acquire first position data reflecting positions on the first electrode sheet for forming the respective first electrode cut portion; a second cutter configured to cut a second electrode sheet to form a second electrode cut portion having a second length, the second electrode sheet including a plurality of second coating patterns, each coating pattern having at least one coated and one uncoated portion; a second sensor arrangement configured to generate a second cutting operation code identifying the operation of the first cutter to form a respective second electrode cut portion, and to acquire second position data reflecting positions on the second electrode sheet for forming the respective second electrode cut portion; a combinator configured to manufacture an electrode assembly by combining the first electrode cut portion and the second electrode cut portion with a separator interposed therebetween; and an identification information assigning device configured to assign identification information to the manufactured electrode assembly and associate the identification information with the first cutting operation code and the first position data reflecting the positions on the electrode sheet corresponding to the first cut electrode portion, and with the second cutting operation code and the second position data reflecting the positions on the electrode sheet corresponding to the second cut electrode portion.

The combinator may be a winder configured to wind the first electrode cut portion and the second electrode cut portion with the separator interposed therebetween to thereby manufacture the electrode assembly. The system may further comprise a first electrode roll from which the first electrode sheet is supplied to the first cutter by unwinding, and a second electrode roll from which the second electrode sheet is supplied to the second cutter by unwinding.

The first sensor arrangement may include at least one first position measuring instrument configured to detect a length of the first electrode sheet supplied to the first cutter, and a first cut counter configured to increase a first cut count value each time the first length of the first electrode sheet is supplied to and cut by the first cutter. The first cutting operation code may include the first cut count value(s).

The second sensor arrangement may include at least one second position measuring instrument configured to detect a length of the second electrode sheet supplied to the second cutter, and a second cut counter configured to increase a second cut count value each time the second length of the second electrode sheet is supplied to and cut by the second cutter. The second cutting operation code may include the second cut count value(s).

The first position measuring instrument may be configured to acquire first coordinate data containing coordinate values that respectively indicate longitudinal positions on the first electrode sheet. The first position data may include the first coordinate data.

The second position measuring instrument may be configured to acquire second coordinate data containing coordinate values that respectively indicate longitudinal positions on the second electrode sheet. The second position data may include the second coordinate data.

The first sensor arrangement may include a first pattern counter configured to acquire a first pattern identification code of a coating pattern on the first electrode sheet supplied to the first cutter. The first pattern identification code may represent a respective one of the plurality of coating patterns by its position on the first electrode sheet. The first position data may include the first pattern identification code.

The second sensor arrangement may include a second pattern counter configured to acquire a second pattern identification code of a coating pattern on the second electrode sheet supplied to the second cutter. The second pattern identification code may represent a respective one of the plurality of coating patterns by its position on the second electrode sheet. The second position data may include the second pattern identification code.

The system may further comprise: a measuring and/or inspecting instrument configured to detect defects on each of the first and second electrode sheets. The identification information assigning device may be configured to associate the identification information with the detected defect.

The system may further comprise: a process controller configured to control the first cutter to cut the first electrode sheet by the first length and to control the second cutter to cut the second electrode sheet by the second length.

The process controller may be configured to, when a defect is detected by the measuring and/or inspecting instrument on one of the first and second electrode sheets, respectively within the first or second length to be supplied to the first or second cutter, control the first cutter and the second cutter to cut only the defective one of the first and second electrode sheets and further control the combinator to combine the cut defective electrode sheet only with the separator and discharge the combined electrode sheet and the separator as a defective electrode assembly.

The identification information assigning device may include: a process controller that is configured to control at least some of multiple process facilities that physically interact with the electrode sheets, or a separate identification information management server communicatively connected to the process controller, or a combination of the process controller and the identification information management server.

The system may further comprise: at least one first electrode measuring and/or inspecting instrument provided between a first electrode roll for supplying the first electrode sheet and the combinator, and at least one second electrode measuring and/or inspecting instrument provided between a second electrode roll for supplying the second electrode sheet and the combinator.

The system may further comprise a monitoring server configured to generate: a first electrode roll map as a graphical representation of the first electrode sheet, the first electrode roll map including first position data of the first electrode sheet supplied to the combinator and first process event data associated with the first position data, the first process event data being data on the first electrode sheet acquired during processing of the first electrode sheet by the battery manufacturing system, and a second electrode roll map as a graphical representation of the second electrode sheet, the second electrode roll map including second position data of the second electrode sheet supplied to the combinator and second process event data associated with the second position data, the second process event data being data on the second electrode sheet acquired during processing of the second electrode sheet by the battery manufacturing system.

The monitoring server may be configured to associate the identification information of the electrode assembly with one or more of the following: lot identification information of the first electrode sheet and lot identification information of the second electrode sheet; data regarding defects of the first electrode sheet and the second electrode sheet or defects of the electrode assembly; the first process event data associated with the first position data and the second process event data associated with the second position data; tray identification information of a tray on which the electrode assembly is loaded; data regarding a loading position of the electrode assembly within the tray; and can identification information of an electrode can in which the electrode assembly is accommodated.

Another aspect of the present invention provides a method for manufacturing an electrode assembly for a battery. The method may comprise at least one of the following steps: supplying a first electrode sheet to a first cutter, the first electrode sheet including a plurality of first coating patterns, each first coating pattern having at least one coated and one uncoated portion; acquiring first position data reflecting positions on the first electrode sheet supplied to the first cutter; cutting, by operating the first cutter, the first electrode sheet to form a first electrode cut portion having a first length; generating a first cutting operation code identifying the operation of the first cutter to form the respective first electrode cut portion; supplying a second electrode sheet to a second cutter, the second electrode sheet including a plurality of second coating patterns, each second coating pattern having at least one coated and one uncoated portion; acquiring second position data reflecting positions of the second electrode sheet supplied to the second cutter; cutting, by operating the second cutter, the second electrode sheet to form a second electrode cut portion having a second length; generating second cutting operation code identifying the operation of the second cutter to form the respective second electrode cut portion; manufacturing an electrode assembly by combining the first electrode cut portion and the second electrode cut portion with a separator interposed therebetween; assigning identification information to the manufactured electrode assembly; and associating the identification information assigned to the electrode assembly with the first cutting operation code and first position data reflecting the positions on the electrode sheet corresponding to the first cut electrode portion, and with the second cutting operation code and second position data reflecting the positions on the electrode sheet corresponding to the second cut electrode portion.

Generating the first cutting operation code may include detecting a length of the first electrode sheet supplied to the first cutter, and increasing a first cut count value each time the first length of the first electrode sheet is supplied to the first cutter.

Generating the second cutting operation code may include detecting a length of the second electrode sheet supplied to the second cutter, and increasing a second cut count value each time the second length of the second electrode sheet is supplied to the second cutter.

Acquiring the first position data may include acquiring a first pattern identification code of a coating pattern on the first electrode sheet supplied to the first cutter. Each first pattern identification code may represent a respective one of the plurality of coating patterns by its position on the first electrode sheet.

Acquiring the second position data may include acquiring a second pattern identification code of a coating pattern on the second electrode sheet supplied to the second cutter. Each second pattern identification code may represent a respective one of the plurality of coating patterns by its position on the second electrode sheet.

Acquiring the first position data may include acquiring first coordinate data containing coordinate values respectively indicating longitudinal positions on the first electrode sheet.

Acquiring the second position data may include acquiring second coordinate data containing coordinate values respectively indicating longitudinal positions on the second electrode sheet.

The first coordinate data may include a first start coordinate value representing one end of the first electrode cut portion and a first end coordinate value representing an opposite end of the first electrode cut portion. The length of the first electrode cut portion may be determined as a difference of the first start and end coordinate values.

The second coordinate data may include a second start coordinate value representing one end of the second electrode cut portion and a second end coordinate value representing an opposite end of the second electrode cut portion. The length of the second electrode cut portion may be determined as a difference of the second start and end coordinate values.

The first electrode sheet may be supplied to the first cutter by being unwound from a first electrode roll and by being wound by a winder.

The second electrode sheet may be supplied to the second cutter by being unwound from a second electrode roll and by being wound by the winder.

The method may further comprise additionally associating the identification information of the electrode assembly with one or more of the following: lot identification information of the first electrode sheet and lot identification information of the second electrode sheet; data regarding defects of the first electrode sheet and the second electrode sheet or defects of the electrode assembly; first process event data associated with the first position data and the second process event data associated with the second position data; tray identification information of a tray on which the electrode assembly is loaded; data regarding a loading position of the electrode assembly within the tray; and can identification information of an electrode can in which the electrode assembly is accommodated.

The method may further comprise at least one of the following steps: inspecting and/or measuring the first and second electrode sheets supplied to the first and second cutters to detect defects on each of the first and second electrode sheets, and when a defect is detected on one of the first and the second electrode sheet: cutting only the electrode sheet on which the defect is detected; combining the cut defective electrode sheet with the separator; and discharging the combined electrode sheet and the separator as a defective electrode assembly.

The separator may be provided with or cut to a third length greater than the first/second lengths before being combined with the first and second electrode cut portions.

The method may further comprise: operating the first/second cutters, using the acquired coordinate values, so that the first/second electrode sheets are initially cut at an uncoated portion of the first/second electrode sheets. The first/second lengths may be preset such that subsequently formed first/second electrode cut portions respectively include at least one coated portion having two uncoated portions positioned at both ends thereof, and such that a number of the coated portion provided on the first electrode cut portion and a number of the coated portion provided on the second electrode cut portion are identical.

The method may further comprise: operating the first cutter, using the acquired coordinate values, so that the first electrode sheet is initially cut at an uncoated portion of the first electrode sheet, wherein the first length is preset such that subsequently formed first electrode cut portions respectively include at least one coated portion having two uncoated portions positioned at both ends thereof, and operating the second cutter, using the acquired coordinate values, so that the second electrode sheet is initially cut at a coated portion of the second electrode sheet, wherein the second length is preset such that each subsequently formed second electrode cut portions include at least one uncoated portion having two coated portions positioned at both ends thereof. The first/second lengths may be further preset such that a number of coated portions provided on the second electrode cut portion is greater than a number of coated portions provided on the first electrode cut portion.

A yet another aspect of the present invention also provides an electrode assembly manufactured by the method in accordance with the present invention.

The electrode assembly may have a physical object formed thereon, wherein the physical object contains the identification information assigned to the electrode assembly in a machine-readable form.

According to the present invention, identification (ID) information can be assigned to an electrode assembly manufactured in a winding process. As a result, it is possible to prevent the occurrence of a gray zone in which the electrode assembly cannot be tracked between the winding process and a subsequent process of the winding process.

In particular, the identification information can be associated with position data (pattern number data, coordinate data) reflecting pattern positions of electrodes with patterns. As a result, it is possible to easily perform quality tracking of electrodes processed in a winding process and an electrode process before the winding process.

According to an exemplary embodiment of the present invention, identification information about an electrode assembly included in, for example, a cylindrical battery or a prismatic battery, can be acquired, and the identification information can be matched to identification information of processed products (e.g., electrodes), semi-finished products, or products before and after the winding process. As a result, it is possible to easily perform quality control and quality tracking throughout the entire battery manufacturing process.

Effects obtainable in exemplary embodiments of the present invention are not limited to the effects described above, and other effects that are not described can be clearly derived and understood by those skilled in the art from the following descriptions to which the exemplary embodiments of the present invention pertain. That is, unintended effects resulting from implementing exemplary embodiments of the present invention may also be derived by those skilled in the art from the exemplary embodiments of the present invention.

### [Brief Description of the Drawings]

FIG. 1 illustrates a battery manufacturing system according to exemplary embodiments.
FIG. 2 illustrates a visualized roll map and patterned electrodes.
FIG. 3 illustrates a battery manufacturing system according to an exemplary embodiment of the invention.
FIG. 4 is a schematic diagram illustrating an example in which an electrode and a separator are wound at a predetermined length by a winder in a method according to an exemplary embodiment of the invention.
FIG. 5 is a schematic diagram illustrating another example in which an electrode and a separator are wound by a winder in a method according to an exemplary embodiment of the invention.
FIG. 6 shows identification information of an electrode assembly that is associated with other information generated in a method according to an exemplary embodiment of the invention.
FIG. 7 is a flowchart for describing a battery manufacturing method according to an exemplar embodiment of the invention.

### [Detailed Description of the Exemplary Embodiments]

Hereinafter, exemplary embodiments of the present invention will be described in detail with reference to the accompanying drawings. Prior to this, terms and words used in this specification and claims should not be interpreted as being limited to commonly used meanings or meanings in dictionaries and should be interpreted with meanings and concepts which are consistent with the technological scope of the present invention based on the principle that the inventors have appropriately defined concepts of terms in order to describe the present invention in the best way.

In addition, in the description of the present invention, when it is determined that detailed descriptions of related well-known configurations or functions unnecessarily obscure the present invention, the detailed descriptions thereof will be omitted.

Since the embodiments of the present invention are provided to more completely explain the present invention to those skilled in the art, the shapes and sizes of components in the drawings may be exaggerated, omitted, or schematically illustrated for clearer description. Therefore, the size or ratio of each component does not entirely reflect the actual size or ratio.

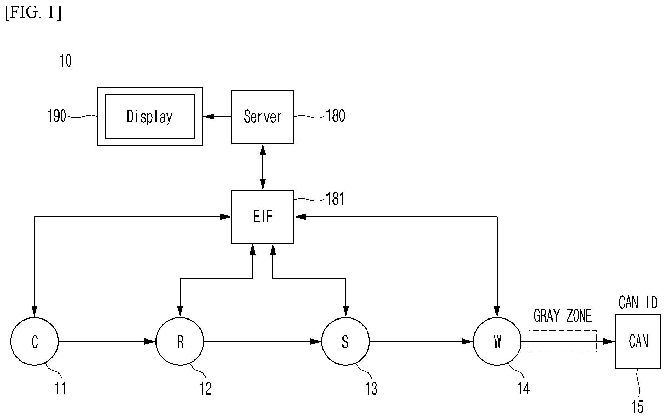

FIG. 1 illustrates a battery manufacturing system 10.

Referring to FIG. 1, the battery manufacturing system 10 may include a coating device 11, a roll pressing device 12, a slitting device 13, a winding device 14, a relay server (e.g., event integration facility (EIF)) 181, a monitoring server 180, and a display device 190.

The battery manufacturing system 10 may be configured to manufacture battery cells (e.g., cylindrical battery cells or prismatic battery cells) by performing a series of roll-to-roll processes. An electrode sheet unwound from a provided electrode roll may be processed by any one of a die coater of the coating device 11, pressing rolls of the roll pressing device 12, and a slitting knife of the slitting device 13, and the processed electrode sheet may be wound around the electrode roll. Accordingly, the processing of the coating device 11, the roll pressing device 12, and the slitting device 13 for production of electrodes of a battery may be referred to as a roll-to-roll process. The winding device 14 may wind a first electrode sheet (e.g., a negative electrode sheet) unwound from a first electrode roll (e.g., a negative electrode roll), a second electrode sheet (e.g., a positive electrode sheet) unwound from a second electrode roll (e.g., a positive electrode roll), and separator sheets unwound from separator rolls together.

The winding device 14 may wind the positive electrode sheet, the negative electrode sheet, and the separators interposed therebetween and separate them after reaching a winding target length to provide an electrode assembly (e.g., a jelly roll-shaped electrode assembly) of a cylindrical battery cell.

The EIF 181 may be a device for communication between process controllers of a manufacturing facility and a server system 200. As necessary, each process controller and the server system 200 may communicate directly. Accordingly, process event data generated in the coating device 11, the roll pressing device 12, the slitting device 13, and the winding device 14 may be transmitted to the monitoring server 180.

The monitoring server 180 may generate monitoring data for battery manufacturing. For example, the monitoring data may include process event data, e.g., data measured and/or inspected on the electrode sheet associated with position data, so that a roll map visually displaying the process event data can be generated. Data in the roll map may include data indicating process events and coordinate values matched or associated with the data. The coordinate values may indicate positions of electrodes. The monitoring server 180 may transmit a visualization command to the display device 190, and the display device 190 may visualize the roll map and display the visualized roll map (VRM).

The roll map may be generated in units of lots. A lot is a production unit in a roll-to-roll process, and an electrode roll that is separated after achieving a target winding length for each process is an example of a lot. Likewise, an electrode roll loaded onto an unwinder of each process is also an example of the lot. The monitoring server 180 may generate and store a roll map of each sub process (e.g., coating process, roll pressing process, or slitting process) of a battery manufacturing process.

The roll map may be a type of a simulating electrode that imitates a moving real electrode (e.g., a real electrode moving between an unwinder and a rewinder). In other words, the roll map may be a visual representation of the electrode in which process event data is shown at a specific position corresponding a position of the real electrode where it has been acquired.

Since process events generally occur as the battery manufacturing process progresses, process event data related to the process events may include time series data. For example, a process controller of each process may control the overall flow of each process. Therefore, it is possible to acquire events that occur according to a time flow of the process or a time of data generation. That is, the process event data may include values indicating or representing respective events and time values matched thereto. Accordingly, the data for the process events may include time series data acquired in each sub-process.

Further, the process event data may include equipment data acquired in the process facilities physically interacting with the electrode sheet. The equipment data may be acquired from a process controller that controls the respective process. The process controller may be a control device used for maintenance, management, automatic control, and monitoring of the respective sub-processes (e.g., coating process, roll pressing process, or slitting process) of the electrode process, an assembly process (e.g., electrode stacking process or winding process), an activation process, a module/pack process, or the like. As the process controller, a process programmable logic controller (PLC) may be representatively used.

The process controller may control facilities related to each process, for example, driving of a motor, a motor rotation speed, etc. required to move the electrode. Additionally or alternatively, the process controller may control process parameters required for each process. As exemplary process parameters, electrode drying temperature and/or electrode temperature may be managed in the coating process, and roll pressing pressure and the like may be adjusted in the roll pressing process. Therefore, the equipment data may include various types of process parameter data managed by the process controller in each process.

Further, the process event data may include process-related measurement data and/or inspection data acquired in each process. For example, in the coating process, an electrode slurry loading amount may be measured or reference points marked on the electrode may be measured. In the roll pressing process, a thickness of the electrode after roll pressing may be measured. Further, an appearance inspecting instrument (e.g., vision inspecting instrument) or the like may be commonly used in the coating process, the roll pressing process, the slitting process, and the like. The measurement data and/or inspection data includes all inspected or measured data by a predefined measuring instrument and/or inspecting instrument in each process.

The process event data may be generated according to the progress of various (sub-)processes performed on the electrode, and the process event data may be acquired for each individual (sub-)process.

Referring to FIG. 1 again, the electrode assembly manufactured by being wound by the winding device 14 may be transferred and accommodated in a case such as a can. A can ID, which is can identification information, may be assigned to the can. The can ID may be considered as a type of a battery cell ID. Therefore, historic data for the manufacture of battery cells may be retrieved based on the can ID.

However, before the electrode assembly is accommodated in the can, in terms of logistics flow, a plurality of electrode assemblies may be accommodated and stored in a tray, or the tray may be transported and transferred to the can. When the plurality of electrode assemblies are mixed up during this process, it is difficult to determine constituent materials (electrodes, separators, etc.) of the electrode assemblies accommodated in the can even when the can ID is assigned during the can manufacturing process. That is, a gray zone in which the electrode assemblies cannot be tracked is generated between the winding process and the can manufacturing process. Accordingly, even when the roll map is generated in each sub-process before the winding process and process event data or coordinate data (CD) related to the electrode of each sub-process is acquired and matched, it is difficult to track the acquired data in relation to the electrodes provided in the electrode assemblies in the various processes between each sub-process and the can manufacturing process.

It is one of the ideas of the present invention to assign identification information ID to an electrode assembly manufactured in the winding process. The identification information may be assigned to the electrode assembly based on cutting operation codes, e.g., in the form of cut count values, and/or pattern identification codes, e.g., in the form of pattern numbers, of electrodes included in the electrode assembly. Thereby, it may be easier to prevent a gray zone in the manufacturing process.

The winding process may include a process in which an electrode and a separator are wound by a winder. Generally, the winding process may include all processes in which electrode sheets and separator sheets unwound from electrode rolls and separator rolls are processed and cut, and wound by a winder. That is, all the unwinding process, the inspection and/or measurement process, the cutting process, and the winding process in the winder may be included in the winding process. A roll map may be generated to imitate the electrodes moving during the winding process.

The roll map generated for the winding process may include position data indicating a position of each electrode moving in the winding process, and process event data. The identification information of the electrode assembly may be associated with the position data of the electrode, and the process event data. The position data of each electrode and the process event data that are acquired during the winding process may be compared with roll map data (position data and process event data) of each process generated in each sub-process prior to the winding process.

Furthermore, the identification information of the electrode assembly may be associated with data acquired in subsequent processes after the winding process (e.g., data related to the tray on which the electrode assembly is loaded, can ID, etc.). Therefore, since the data associated with each electrode assembly can be retrieved between the winding process and the subsequent process based on the identification information, quality may be easily tracked between the winding process and subsequent processes.

In conclusion, through the identification information of the electrode assembly, all historic data related to the quality or manufacturing of the electrode may be tracked throughout the winding process and all pre- and post-processes. Accordingly, process management and quality control may be performed efficiently throughout the entire battery manufacturing process, and the battery may be more reliably manufactured.

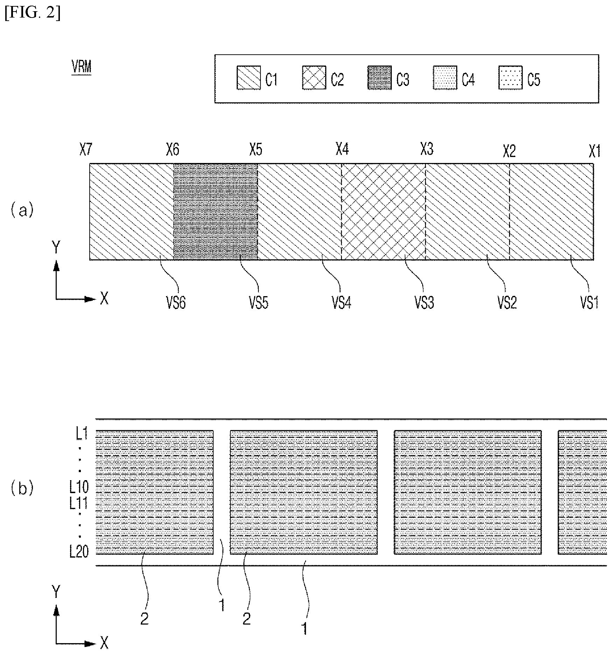

FIG. 2 illustrates a visualized roll map and patterned electrodes.

In FIG 2, arrow X indicates a longitudinal direction (traveling direction) of an electrode (roll map), and arrow Y indicates a width direction of the electrode (roll map).

A visualized roll map (VRM) in FIG. 2A may include a plurality of visualization sections VS1, VS2, VS3, VS4, VS5, and VS6 corresponding to a plurality of sections of an electrode sheet. Each of the plurality of visualization sections VS1, VS2, VS3, VS4, VS5, and VS6 may include start coordinates, end coordinates, and color.

A representative value of coordinate-related measurement data (CMD) of the visualization sections VS1, VS2, VS4, and VS6 may be displayed in color C1, a representative value of coordinate-related measurement data (CMD) of the visualization section VS3 may be displayed in color C2, and a representative value of coordinate-related measurement data (CMD) of the visualization section VS5 may be displayed in color C3.

The color C1 may indicate that the representative value of the visualization sections VS1, VS2, VS4, and VS6 is normal, the color C2 may indicate that the representative value of the visualization section VS3 is excessive, and the color C3 may indicate that the representative value of the visualization section VS3 is very excessive. Color C4 may indicate that a representative value is insufficient, and color C5 may indicate that a representative value is very insufficient.

In this way, since the roll map expresses the position of the electrode in coordinates and can visualize measurement data (e.g., electrode slurry loading amount data) according to each position, the efficiency of electrode production management may be improved using the roll map and the data included therein.

FIG. 2B illustrates a patterned electrode having coating patterns in which electrode coated portions 2 and uncoated portions 1 are repeatedly arranged in the longitudinal direction. Generally, within the meaning of the present disclosure, a patterned electrode includes a plurality of coating patterns, wherein each coating pattern has at least one coated and one uncoated portion. In the example shown in FIG. 2 B, multiple coating patterns are arranged neighboring to each other in the longitudinal direction of the electrode, and each coating pattern is formed by one coated portion and one uncoated portion. However, the present invention is not limited to this specific form of coating patterns. In the following, a "coating pattern" may also be referred to simply as "pattern".

The patterned electrode may be slit in a width direction in the uncoated portion 1 between the electrode coated portions 2 in a subsequent process. The slit electrode coated portion 2 may be stacked with electrode coated portions and separators of different polarity so that an electrode assembly is formed, or may be wound together with electrode coated portions and separators of different polarity so that a jelly roll-shaped electrode assembly is formed.

In particular, patterned electrodes used for small batteries may be slit in a width direction and at the same time, slit in a longitudinal direction of the patterned electrode so that a plurality of electrode lanes L1 to L20 are formed.

Unlike a typical electrode which is continuously coated in a longitudinal direction, the patterned electrode has electrode coated portions formed intermittently or spaced to oneanother. Therefore, the roll map method as illustrated in FIG. 2A, which indicates the longitudinal positions of the electrode as length coordinates in succession, may not be suitable for the patterned electrodes. For example, the uncoated portions of the patterned electrode have loading amounts corresponding to measured values of 0 and are not significant portions that affect actual battery performance. Thus, there is no need to display these portions in detail by linking measurement data and coordinates in these portions. Further, the patterned electrodes are made into an electrode assembly according to the length and width of the electrode coated portions 2 forming part of a respective pattern. That is, the electrode production result may be counted as the number of electrode coated portions 2 or the number of patterns including the electrode coated portions 2. In this way, for the patterned electrode, it would be advantageous to assign position data according to the characteristics of the patterned electrode on the basis of the pattern. It is one of the ideas of the present invention to provide a battery manufacturing method and battery manufacturing system that can generate monitoring data on the basis of pattern identification data, which is position data representing respective patterns on the patterned electrode. Preferably, the position data are virtually assigned to respective patterns - in other words, without providing corresponding physical identifications to the patterned electrode itself. This apparently can bring about many advantageous effects in the battery manufacturing process, compared to the other case of assigning/providing corresponding physical identifications to the electrode itself.

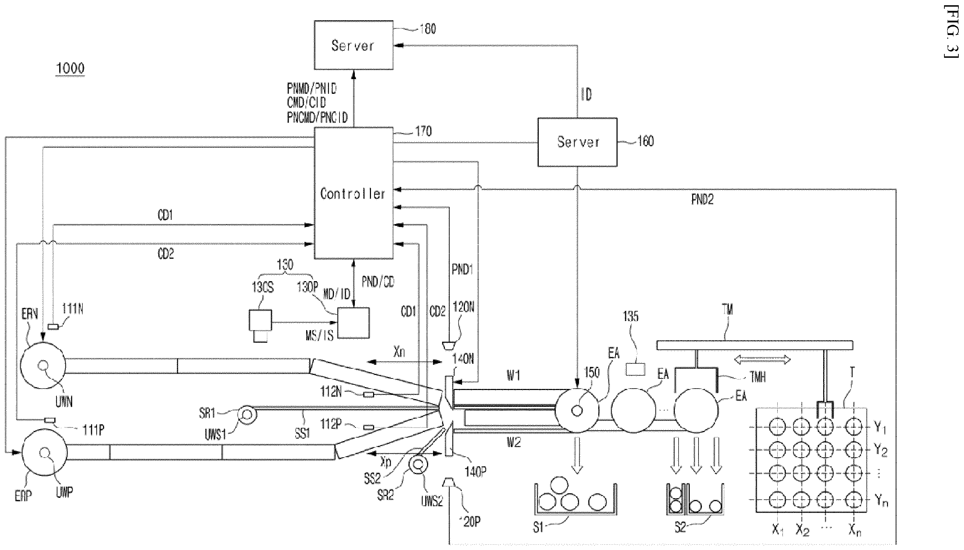

FIG. 3 exemplarily illustrates a battery manufacturing system.

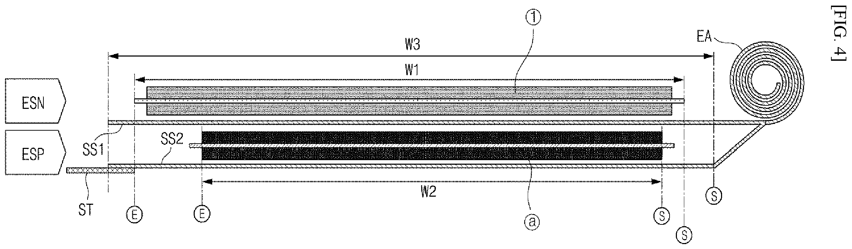

FIG. 4 is a schematic diagram illustrating an example in which an electrode and a separator are wound at a predetermined length by a winder.

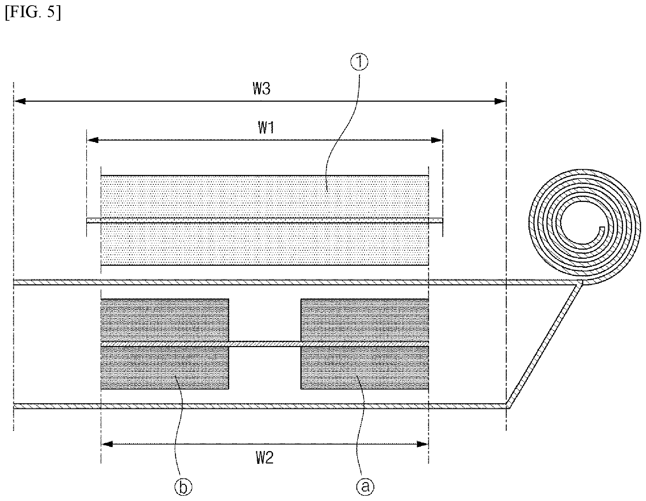

FIG. 5 is a schematic diagram illustrating another example in which an electrode and a separator are wound by a winder.

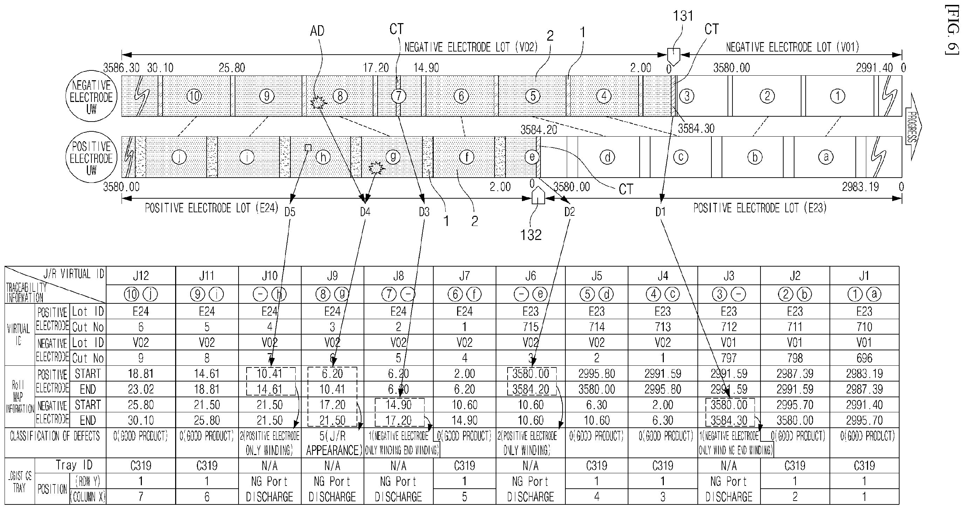

FIG. 6 shows identification information of an electrode assembly that is associated with other information.

Referring to FIG. 3, the battery manufacturing system 1000 may include unwinders UWN, UWP, UWS1, and UWS2, first position measuring instruments 111N and 112N, second position measuring instruments 111P and 112P, a first pattern counter 120N, a second pattern counter 120P, various types of measuring instrument and/or inspecting instruments 130, a first cutter 140N, a second cutter 140P, a winder 150, an identification information management server 160, a process controller 170, and a monitoring server 180. The first position measuring instruments 111N and 112N and the first pattern counter 120N may form a first sensor arrangement. The second position measuring instruments 111P and 112P and the second pattern counter 120P may form a second sensor arrangement.

In this specification, for convenience of description, "first" is attached to data acquired for a first electrode sheet ESN, a device related to the first electrode sheet ESN, and the like, and "second" is attached to data acquired for a second electrode sheet ESP, a device related to the second electrode sheet ESP, and the like.

A first electrode roll ERN may be loaded onto an unwinder 111N. The unwinder 111N may be configured to unwind, for example, the first electrode sheet ESN from the first electrode roll ERN. The first electrode sheet ESN may be a negative electrode sheet.

A second electrode roll ERP may be loaded onto an unwinder 111P. The unwinder 111P may be configured to unwind, for example, the second electrode sheet ESP from the second electrode roll ERP. The second electrode sheet ESP may be a positive electrode sheet.

A separator roll SR1 may be loaded onto an unwinder UWS1, and a separator roll SR2 may be loaded onto an unwinder UWS2. The unwinders UWS1 and UWS2 may be configured to unwind the separator sheets SS1 and SS2, respectively.

The first electrode sheet ESN, the second electrode sheet ESP, and the separator sheets SS1 and SS2 may be guided by a guide roll (not illustrated in FIG. 3), respectively, and moved toward the cutters 140N and 140P and the winder 150. A plurality of guide rolls may be provided to correspond to a movement path of each sheet. Each sheet guided by each guide roll may join in front of the cutters 140N and 140P.

Before being transferred to the battery manufacturing system 1000, each of the first electrode roll ERN and the second electrode roll ERP may have been processed in one or more previous sub-processes (e.g., coating process, roll pressing process, and slitting process). The electrode rolls may include defective tags (NG tags) attached in the previous sub-process (e.g., roll pressing process or slitting process). Instead of the defective tag, defective parts may be marked directly on the electrode. Therefore, the electrode rolls may include defective marking portions marked on the electrode in the previous sub-process. Additionally or alternatively, the electrode rolls may include reference points marked at predetermined intervals on the electrode in a previous sub-process (e.g., coating process). Additionally or alternatively, the electrode rolls may include connection portions that connect electrode portions cut by fracture or defect removal during the previous sub-process, between the previous sub-processes, or after a respective previous sub-process. For example, connecting tape (adhesive tape) is attached to the connection portion. By detecting positions of the reference point, the connection portion, and the defective marking portion (including defective tags) of each electrode unwound from each electrode roll by the unwinder in the winding process, it is possible to determine a change in length of each electrode sheet in the previous sub-process. The change in length may be displayed or reflected in the roll map. Monitoring data for making up the roll map information for each previous sub-process may be stored in the monitoring server 180. Therefore, process control in the winding process may be efficiently performed using the roll map information or monitoring data for each sub-process. Further, as will be described below, events occurring while the electrode sheet is moving in the winding process are detected, and when the positions of the above-described reference point, connection portion, or defective marking portion are changed due to the above event, the positions may be displayed in the roll map of the winding process containing the process event data of the winding process. Furthermore, by comparing the roll map of the winding process with the roll map of each previous sub-process, changes in electrodes that occurred between several processes may be identified.

The first electrode sheet and the second electrode sheet each are patterned electrode sheets as illustrated in FIG. 2B. Generally, within the meaning of the present disclosure, a patterned electrode includes a plurality of coating patterns, wherein each coating pattern has at least one coated and one uncoated portion. In the example shown in FIG. 2B, multiple coating patterns are arranged neighboring to each other in the longitudinal direction of the electrode, and each coating pattern is formed by one coated portion and one uncoated portion. However, the present invention is not limited to this specific form of coating patterns. In the following, a "coating pattern" may also be referred to simply as "pattern".

Position data reflecting positions on the electrode sheet may include pattern identification data. The pattern identification data includes pattern identification codes, e.g., in the form of pattern numbers. Each pattern identification code indicates a position of a respective pattern on the electrode sheet. The pattern identification data PND1 and PND2 may be acquired, for example, by counting the successively arranged individual patterns, and pattern numbers may be acquired as pattern identification codes, so that the pattern number increases or decreases for each counted coating pattern.

In order to distinguish the positions of the patterns on the first and second electrode sheets, the pattern identification codes assigned to the patterns of the first electrode sheet are referred to as first pattern identification codes, and the pattern identification codes assigned to the patterns of the second electrode sheet are referred to as second pattern identification codes. Therefore, the first pattern identification codes may indicate the positions of the first electrode sheet moving between the first electrode roll and the winder. Further, the second pattern identification codes may indicate the positions of the second electrode sheet moving between the second electrode roll and the winder.

The first pattern counter 120N may count patterns on the first electrode sheet ESN moving between the first electrode roll ERN and the winder 150.

The second pattern counter 120P may count patterns on the second electrode sheet ESP moving between the second electrode roll ERP and the winder 150.

The pattern counters may be installed at the same positions as the first cutter 140N and the second cutter 140P adjacent to the winder 150 or adjacent positions thereto. Therefore, when the cutters acquire cutting operation codes, e.g., in the form of cut count values, the pattern counters may also count the pattern numbers of the electrode sheets to be cut.

Each of the first and second pattern counters 120N and 120P may include a pitch sensor and a trigger board. The pitch sensor may measure a length of each pattern, that is, a pitch of each pattern.

For example, the pitch sensor may be a photoelectric sensor or include a photoelectric sensor. The photoelectric sensor may comprise a light emitting unit and a light receiving unit. When light emitted from the light emitting unit is blocked or reflected by an object to be detected, an amount of light reaching the light receiving unit changes. The light receiving unit detects the change, converts the change into an electrical signal, and outputs the electrical signal. The amount of light emitted from the light emitting unit reaching the light receiving unit changes based on a boundary between the electrode coated portion 2 and the uncoated portion 1 on the patterned electrode. Accordingly, the pattern counter equipped with the pitch sensor may distinguish the electrode coated portion 2 and the uncoated portion 1 on the patterned electrode. An optical fiber sensor may be used as the photoelectric sensor. The optical fiber sensor uses an optical fiber instead of a lens of the photoelectric sensor, and since the optical fiber, which is a detection part, has no electrical part, there is an advantage of excellent environmental resistance such as noise resistance.

The pitch sensor may transmit a length of the detected pattern to the trigger board. The trigger board may generate count information for each pattern based on the length of each pattern received from the pitch sensor. The count information may form the pattern identification data, and the trigger board may increase a count value for each length corresponding to the length of a detected pattern. The trigger board may increase binary coded decimal (BCD) code by 1 whenever the count value for the length of each pattern increases. The trigger board may convert the count value for each length of the generated pattern into BCD code and transmit the BCD code to the process controller or the server. Thus, the patterns are preferably counted in a systematic manner and a pattern number is assigned to each pattern as the pattern identification code so as to be able to specify the position of a respective pattern on the electrode. Thereby, a position on the electrode may easily be found by counting the patterns starting from a known position/pattern.

The pattern identification data PND 1 and PND2 and coordinate data CD may be used together to indicate the longitudinal position of the electrode sheet. For example, the pattern identification data PND 1 and PND2 containing the pattern identification codes that indicate the positions of the electrode sheet may be acquired, and at the same time, the coordinate data CD containing the coordinate values that can indicate the longitudinal positions may be further acquired. Thus, position data reflecting positions on the respective first or second electrode sheet may include at least one of coordinate data CD and pattern identification data PND 1, PND2.

The coordinate data includes coordinate values indicating a specific position on the electrode sheet in the longitudinal direction of the electrode sheet. The coordinate values and a difference between the coordinate values directly indicate the position of the electrode sheet or a distance of a specific section. Therefore, by acquiring the coordinate data, it is possible to acquire more accurate position information about the electrode sheet by excluding the influence of the moving speed of the electrode sheet without performing additional calculations. By associating the coordinate data with the pattern identification data PND, with the measurement data and/or the inspection data, or with the measurement data and/or inspection data associated with the pattern identification data PND, status information about the electrode sheet may be acquired more accurately and reliably.

Further, based on a difference in coordinate values between start and end boundaries of a respective pattern, a difference in coordinate values between start and end boundaries of the coated portion, and a difference in coordinate values between start and end boundaries of the uncoated portion, a length of the electrode coated portion, a length of the uncoated portion, and a length of the pattern may be easily determined. By comparing the determined length of the pattern with a set pattern pitch or target pattern length, over- or under-pitched patterns, that is, patterns that are too long or to short, may be easily identified.

The first pattern identification data PND1 including first pattern identification codes, e.g., in the form of first pattern numbers, acquired by the first pattern counter 120N, and the second pattern identification data PND2 including second pattern identification codes, e.g., in the form of first pattern numbers, acquired by the second pattern counter 120P may be transmitted to the process controller 170.

The first position measuring instruments 111N and 112N and the second position measuring instruments 111P and 112P are provided to acquire coordinate data.

The first position measuring instruments 111N and 112N may acquire first coordinate data that indicates the positions of the first electrode sheet ESN moving between the first electrode roll ERN and the winder 150.

Among the first position measuring instruments, the first position measuring instrument 111N installed at the unwinder UWN may be configured to detect an amount or length of the electrode sheet ESN unwound from the electrode roll ERN by the unwinder. Accordingly, the first position measuring instrument 111N may be configured to generate an unwinding amount signal indicating the unwinding amount of the electrode sheet ESN. The first position measuring instrument 111N may convert the unwinding amount signal to directly acquire input amount data corresponding to coordinate data. Alternatively, the first position measuring instrument 111N may transmit the unwinding amount signal to the process controller 170, and the process controller 170 may convert the signal to collect or acquire the first coordinate data.

The first position measuring instrument 112N may be installed at the first cutter 140N, e.g., near a guide roll where the sheets join. The first position measuring instrument 112N may be configured to detect the amount or length of the first electrode sheet ESN moving to the winder 150. Accordingly, the first position measuring instrument 112N may be configured to detect the consumption amount of the first electrode sheet ESN moving to the winder 150. The first position measuring instrument 112N may convert the consumption amount to directly acquire the first coordinate data. Alternatively, the first position measuring instrument 112N may transmit the consumption amount to the process controller 170, and the process controller 170 may convert the signal to collect the coordinate data. Generally, the first position measuring instrument 112N may be configured to detect a length of the first electrode sheet supplied to the first cutter 140N.

The second position measuring instruments 111P and 112P may acquire second coordinate data CD2 that can indicate the positions of the second electrode sheet ESP moving between the second electrode roll ERP and the winder 150 in succession.

Among the second position measuring instruments 111P and 112P, the second position measuring instrument 111P installed at the unwinder UWP may acquire the second coordinate data of the second electrode sheet ESP based on the unwinding amount signal. Among the second position measuring instruments 111P and 112P, the second position measuring instrument 112P installed on the second cutter 140P may acquire the second coordinate data based on the signal of the consumption amount. Generally, the second position measuring instrument 112P may be configured to detect a length of the second electrode sheet supplied to the second cutter 140P.

The first and second position measuring instruments may be rotary encoders that can indicate the position signal of the electrode sheet moving according to the rotation amount of the unwinder or guide roll as an encoder value. Alternatively, the first and second position measuring instruments may be linear encoders that represent a position signal corresponding to the moving displacement of the electrode sheet as an encoder value. The encoders may be configured in contact or non-contact with the electrode sheet. The encoders may be equipped with a calculation unit configured to convert the encoder value into the coordinate value. Alternatively, the process controller may receive the encoder value and convert the encoder value into the coordinate value through a predetermined operation. In consideration of the computational load of the process controller, the encoders may directly convert the encoder value into the coordinate value.

The first position measuring instrument 112N may be installed at a certain first distance Xn to the first cutter 140N. Therefore, the coordinate value of the first electrode sheet ESN supplied to the first cutter 140N may be corrected by adding the first distance Xn to the coordinate value of the first electrode sheet ESN acquired based on the sensing signal of the first position measuring instrument 112N.

The econd position measuring instrument 112P may be installed at a certain second distance Xp to the second cutter 140P. Therefore, the coordinate value of the second electrode sheet ESP supplied to the second cutter 140P may be corrected by adding the second distance Xp to the coordinate value of the second electrode sheet ESP acquired based on the sensing signal of the second position measuring instrument 112P.

The pattern identification data of the first and second electrode sheets ESN and ENP acquired, for example, by the first and second pattern counters 120N and 120P may be directly transmitted to the monitoring server 180 or may be transmitted to the monitoring server 180 through the process controller 170.

Further, each piece of coordinate data of the first and second electrode sheets ESN and ENP acquired by the first and second position measuring instruments 111N, 111P, 112N, and 112P may be directly transmitted to the monitoring server 180 or may be transmitted to the monitoring server 180 through the process controller 170.

Further, the pattern identification codes and the coordinate values acquired from the same physical part of the electrode may be associated with each other. The pattern identification data and the coordinate data may be associated with each other, for example, based on the same time or time section at which each data was acquired. For example, the coordinate data may be acquired as time series data in which each coordinate value is matched with one time value, respectively. The pattern identification data may also be time series data. The pattern identification data includes pattern identification codes, e.g., in the form of pattern numbers, and data regarding a time or time section at which the pattern identification codes are acquired, e.g., the detection time points at which the start and end boundary lines of a respective pattern are detected. Said time points or time section may be matched or associated with the respective pattern identification code, e.g., in the form of a pattern number. To associate the pattern identification data and the coordinate data, the pattern identification codes may be associated with the coordinate values and/or inspection values based on the time value(s) commonly matched to them. The association between the pattern identification codes and the coordinate values may be performed in one of the processing unit of the measuring instrument and/or inspecting instrument, which will be described below, the process controller, and the server.

Further, the coordinate data and the pattern identification data associated therewith may be associated with at least one of the identification information of the electrode assembly, the cutting operation codes of the first electrode sheet, and the cutting operation codes of the second electrode sheet, which will be described below.

The battery manufacturing system 1000 may optionally include an additional position measuring instrument that can detect a position signal of each of the separator sheets SS1 and SS2.

The first electrode sheet ESN moved or supplied to the first cutter 140N by the guide roll is cut by the first cutter 140N by a first length W1. Thereby, a first electrode cut portion having the first length W1 is formed.

The second electrode sheet ESP moved or supplied to the second cutter 140P by the guide roll is cut by the second cutter 140P by a second length W2. Thereby, a first electrode cut portion having the first length W1 is formed.

The unwinders UWN and UWP, the guide roll, the first cutter 140N, the second cutter 140P, and the winder 150 may be controlled by the process controller 170.

The cutters 140N and 140P may include a predetermined cutting device (e.g., a cutting blade) and a moving mechanism for moving the cutting device. Further, the cutters 140N and 140P may include a sensor (e.g., photoelectric sensor) that is configured to distinguish between the coated portion and the uncoated portion on the electrode sheet. The first cutter 140N and the second cutter 140P may include, for example, a cut counter (not illustrated) equipped with a trigger board (not illustrated) in order to calculate a cut count value. The trigger board may generate cut count information on the basis of each length (first length or second length). The trigger board may increase the count value each time the first or second length of the respective electrode sheet received and cut by the respective cutter 140N, 140P. The trigger board may convert the generated cut count value of each electrode sheet into the form of BCD code and transmit the BCD code to the process controller. Generally, a cut counter may be assigned to each of the cutters 140N, 140P, wherein the respective cut counter is configured to increase a first or second cut count value each time the first or second length of the first electrode sheet or second electrode sheet is supplied to and cut by the respective cutter. The cutting operation code may include the respectively generated cut count value(s).

The first cutter 140N may cut the first electrode sheet ESN by the first length W1 according to an instruction of the process controller 170.

The second cutter 140P may cut the second electrode sheet ESP by the second length W2 according to an instruction of the process controller 170.

The process controller 170 may control the first cutter 140N to cut the first electrode sheet ESN by the first length W1. Further, the process controller 170 may control the second cutter 140P to cut the second electrode sheet ESP by the second length W2. The process controller 170 may control each cutter based on information on the first length W1, the second length W2, and a third length W3. The process controller 170 may determine a total length of the first electrode sheet ESN unwound from the first electrode roll ERN that is fed or supplied to the first cutter 140N, a total length of the second electrode sheet ESP unwound from the second electrode roll ERP that is fed or supplied to the second cutter, and a total length of each of the separators unwound from each separator roll fed or supplied to the cutters. For example, the process controller 170 may receive a signal or data representing an amount (input amount) or length of each electrode sheet unwound or a signal or data regarding an amount (consumption amount) or length reaching the cutters 140N and 140P, from the first position measuring instrument and the second position measuring instrument described above. Based on the signal and the data, the process controller 170 may determine the total length of each electrode sheet supplied to the respective cutter. Based on the information about the total length of electrode sheet that is supplied to the respective cutter and information about the pattern length (pattern pitch), the process controller 170 may determine when an amount of the electrode sheet corresponding to the first or second length is supplied to the respective cutter. Therefore, the process controller 170 may control each cutter to cut each electrode sheet by the corresponding first or second length.

The first cutting operation code, which may, for example, contain the cut count value of the first electrode sheet cut by the first cutter 140N, and the second cutting operation code, which may, for example, contain the cut count value of the second electrode sheet cut by the second cutter 140P, may be transmitted to the process controller 170.

To inspect the first electrode sheet ESN and the second electrode sheet ENP, one or more first electrode measuring instruments and/or inspecting instruments may be provided between the first electrode roll and the winder, and one or more second electrode measuring instruments and/or inspecting instruments are provided between the second electrode roll and the winder.

For convenience of description, although only one measuring instrument and/or inspecting instrument 130 is illustrated in FIG. 2, the measuring instrument and/or inspecting instrument may be provided for each electrode sheet.

For example, the measuring instrument and/or inspecting instrument 130 may include a reference point measuring instrument configured to acquire the position of a reference point marked on the respective electrode sheet. Additionally or alternatively, the measuring instrument and/or inspecting instrument 130 may include an appearance inspecting instrument (e.g., a vision inspecting instrument) for inspecting defects on the respective electrode sheet. Additionally or alternatively, the measuring instrument and/or inspecting instrument 130 may include a seam sensor 131 for detecting the connecting tape on the respective electrode sheet. The measuring instrument and/or inspecting instrument 130 is not limited to the types described above.

Each measuring instrument and/or inspecting instrument 130 may include a sensing unit 130S and a processing unit 130P. The sensing unit 130S and the processing unit 130P may be connected in a wired or wireless manner.

The sensing unit 130S may include an imaging device such as a time delay and integration (TDI) camera, a complementary metal oxide semiconductor (CMOS) image sensor, etc. The sensing unit 130S may be configured to generate an inspection signal IS representing properties of a surface of each of the electrode sheets ESN and ESP or a measurement signal MS representing a size or width of the electrode sheet, for example. The sensing unit 130S may transmit the inspection signal IS or the measurement signal MS to the processing unit 130B.

The processing unit 130P may be configured to determine a quality indicator value indicating whether the electrode sheets ESP and ESN are defective based on the inspection signal IS and/or the measurement signal MS. The processing unit 130B may be configured to generate determination values of the electrode sheets ESP and ESN by processing the inspection signal IS and/or the measurement signal MS using a set algorithm.

The processing unit 130P may be configured to acquire position-related measurement data and/or inspection data on the basis of the inspection signal IS and/or the measurement signal MS, the position data, which may include pattern identification data PND and/or coordinate data CD. For example, the processing unit 130P may collect measurement data and/or inspection data PNMD/PNID associated with the pattern identification data. In this case, the pattern identification data PND1 and PND2 may be transmitted from the first and second pattern counters to the processing unit 130P directly or through the process controller 170.

For example, the processing unit 130P may collect measurement data and/or inspection data CMD/CID associated with the coordinate data. In this case, the coordinate data CD1 and CD2 may be transmitted from the first and second position measuring instruments to the processing unit 130P directly or through the process controller 170.

For example, the processing unit 130P may collect measurement data and/or inspection data PNCMD/PNCID associated with the pattern identification data and the coordinate data. In this case, the pattern identification data, the coordinate data, and the measurement data and/or the inspection data may be associated with each other based on the time value(s) commonly matched to them .

The processing unit 130P may transmit the measurement data and/or the inspection data associated with the position data (pattern identification data PND and/or coordinate data CD) to the server 180 directly or through the process controller 170.

Each cut portion of the first electrode sheet ESN of the first length W1 moves to the winder 150 together with the separator sheet SS1. Further, each cut portion of the second electrode sheet ESP of the second length W2 moves to the winder 150 together with the separator sheet SS2. Each separator sheet may move to the winder 150 without being cut in advance so as to support the moving electrode sheet.

The winder 150 may be configured to wind the first electrode sheet ESN, the separator sheet SS1, the second electrode sheet ESP, and the separator sheet SS2 together. Accordingly, an electrode assembly EA of a battery (e.g., a cylindrical cell) may be provided. The electrode assembly EA may include a winding structure of a first electrode sheet ESN, a separator sheet SS1, a second electrode sheet ESP, and a separator sheet SS2. The first electrode sheet ESN and the second electrode sheet ESP may be electrically isolated by the separator sheets SS1 and SS2. Accordingly, despite the winding of each sheet, a short circuit of the first electrode sheet ESN and the second electrode sheet ESP may be prevented. The separator sheets may be cut by a separator cutter (not illustrated) after winding.

In the system 1000 exemplarily shown in FIG. 3 and described above, the first electrode cut portion, the second electrode cut portion, and the separator are combined by the winder 150 by being wound together. However, the invention is not limited to a winder 150 but other types of combinators configured to combine the first electrode cut portion, the second electrode cut portion, and the separator may be provided.

As described above, the first electrode sheet ESN and the second electrode sheet ESP may be cut first and being wound with the separator sheets afterwards.

However, it is also possible to wind the electrode sheets and separator therebetween first, and cut a connecting portion between an end of the wound electrode assembly and each electrode sheet, and cut a connecting portion between the end and the separator afterwards. In this case, after the separator sheet SS2, the second electrode sheet ESP, the separator sheet SS1, and the first electrode sheet ESN each reach a target length, the corresponding cutter may cut the separator sheet SS2, the second electrode sheet ESP, the separator sheet SS1, and the first electrode sheet ESN for separation of the electrode assembly EA.

The manufactured electrode assembly EA may be discharged or output by the winder 150 or, generally, the combinator. The discharged electrode assembly EA may be inspected by a separate inspecting instrument 135 and then transferred to a tray T by a predetermined transfer device TM. When an electrode assembly EA is determined to be defective by the inspecting instrument 135, it may be discharged to a defect storage port S2.

When an electrode assembly EA is determined to be normal, i.e., as being not defective, it may be output to a storage port S1. The electrode assembly EA of the storage port S1 may be gripped by, for example, a gripper TMH of the transfer device TM, and transferred to the tray T in accordance with a predefined logistics transport schedule. The tray T may include a plurality of storage positions for receiving electrode assemblies EA. Each electrode assembly EA may be stored at a specific storage position within the tray T, for example, sequentially according to a transfer order or according to a separate loading algorithm. For example, when a plurality of rows X1, X2, ..., Xn and columns Y1, Y2, ..., Yn are present within the tray T, a tray loading position of the electrode assembly EA may be specified by ordered pairs of a matrix indicated by intersection of the rows and columns.

The electrode rolls ERN and ERP loaded onto the respective unwinder constitute a lot. When loading each electrode roll onto the respective unwinder, identification information, e.g., a lot number, of each lot may be read by a predetermined reader, e.g., a BCR reader. Alternatively, the lot identification information of the corresponding electrode roll may be input into a facility or system through manual input by operators. Alternatively, a code indicating the lot identification information may be included in a reference point, defect marking, or otherwise physically marked on the electrode. Further, when the seam sensor 131, which is one of measuring instruments disposed on the movement paths of the first and second electrode sheets, detects a connecting tape CT on the first or the second electrode sheet, lot numbers of the first electrode roll and the second electrode roll may be updated based on a detection signal. Accordingly, coordinate values of the first electrode sheet ESN and coordinate values of the second electrode sheet ESP may be reset based on a seam detection signal.

Accordingly, the lot identification information of the first electrode sheet ESN and the lot identification information of the second electrode sheet ESP input in the winding process may be identified. Further, past manufacturing historic information, for example, roll map information, of the first and second electrode sheets may be identified based on the lot identification information.

Meanwhile, since the completed electrode assembly EA is loaded onto the tray as described above, the identification information (e.g., tray ID) of the tray T to which the electrode assembly EA is loaded, may be associated with the corresponding electrode assembly EA. Further, the loading position of the corresponding electrode assembly on the tray may be identified.

However, as described above, in terms of logistics flow, when a plurality of electrode assemblies EA are mixed up in the process of being accommodated in the tray, it is not possible to determine what material (electrode, separator, etc.) the electrode assembly EA accommodated in the can is made of even when the can ID is assigned during the can manufacturing process. For this reason, even when there is the manufacturing historic information such as the roll map information for the electrode in each sub-process before the winding process, it becomes difficult to associate with the manufacturing historic information of the electrode included in the electrode assembly EA loaded onto the tray T or the can.

In order to prevent the above difficulty, the battery manufacturing system 1000 of the present invention includes an identification information assigning device for assigning identification information to an electrode assembly EA.

The identification information of the electrode assembly EA is associated with information that specifies an electrode included in the corresponding electrode assembly EA. In the winding process, a plurality of electrode sheet portions are cut and wound. Therefore, the identification information of the electrode assembly EA may be assigned based on information that can specify a portion of the first electrode sheet of the first length W1 and a portion of the second electrode sheet of the second length W2.

For example, the identification information of the electrode assembly EA may be assigned to the manufactured electrode assembly and associated with the first cutting operation code and the first position data reflecting the positions on the electrode sheet corresponding to the first cut electrode portion, and with the second cutting operation code and the second position data reflecting the positions on the electrode sheet corresponding to the second cut electrode portion.

The first cutting operation codes, e.g., in the form of first cut count values of the first electrode sheet and the second cutting operation codes, e.g., in the form of second the cut count values of the second electrode sheet may be acquired by the first cutter 140N and the second cutter 140P, respectively.

The first position data may include, for example, first pattern identification data, e.g. in the form of first pattern numbers of the first electrode sheet corresponding to the first length, and may be acquired by the first pattern counter 120N. The second position data may include second pattern identification data, e.g., in the form of the second pattern numbers of the second electrode sheet corresponding to the second length, and may be acquired by the first pattern counter 120N and the second pattern counter 120P.

The process controller 170 may assign the identification information ID of the wound electrode assembly EA on the basis of the received first cutting operation code of the first electrode sheet ESN, the received second cutting operation code of the second electrode sheet ESP, the first pattern identification code of the first electrode sheet corresponding to the first length, and the second pattern identification code of the second electrode sheet corresponding to the second length. That is, for example, when a specific portion of the first electrode sheet ESN is cut to have the first length W1, a cut order may be counted as a specific cut count value, and a specific pattern number of the pattern(s) included in the specific portion of the first electrode sheet ESN may be counted as a first pattern number, specific identification information ID may be assigned to the wound electrode assembly EA including the first electrode sheet ESN of the specific portion. Hence, the length portion of the first electrode sheet included in the electrode assembly to which the identification information ID is assigned, may be reflecting by the first pattern number(s).

Similar, when a specific portion of the second electrode sheet ESP is cut to have the second length W2, a cut order may be counted as a specific cut count value, and a specific pattern number of pattern(s) included in the specific portion of the second electrode sheet ESP may be counted as a second pattern number, specific identification information ID may be assigned to the wound electrode assembly EA including the second electrode sheet ESN of the specific portion. Hence, the length portion of the second electrode sheet included in the electrode assembly to which the identification information ID is assigned, may be reflecting by the second pattern number(s).

In this case, an ID of the electrode assembly EA may be assigned by physically marking it on the electrode assembly. However, the ID of the electrode assembly EA may also be a virtual ID in which the process controller 170 virtually assigns identification information to the corresponding electrode assembly EA.

Since the process controller 170 is in data communication with the first and second cutters 140N and 140P and the first and second pattern counters 120N and 120P, the process controller 170 may assign an ID to the electrode assembly EA on the basis of the cut count values and first and second pattern numbers of the first and second electrode sheets described above or, generally, may associate the identification information with the first cutting operation code and the first position data reflecting the positions on the electrode sheet corresponding to the first cut electrode portion, and with the second cutting operation code and the second position data reflecting the positions on the electrode sheet corresponding to the second cut electrode portion. That is, the process controller 170 may be an identification information assigning device.

However, the process controller 170 is provided for controlling the unwinder, the cutter, the winder, and the like. Therefore, when an operation for assigning the ID of the electrode assembly EA or an ID issuing function is provided to the process controller 170, an overload may be applied to the process controller 170. In this case, there is the risk that a control speed of the process controller 170 may become slow. To reduce this risk, a dedicated server for assigning and managing identification information may be added. As exemplarily shown in FIG. 3, an identification information management server 160 connected to the process controller 170 to allow data communication may be provided. The identification information management server 160 may be, for example, an edge computer system (ECS) and/or an equipment data collection (EDC) server.

The identification information management server 160 may receive the cutting operation codes, e.g., the cut count values, and the pattern identification codes, e.g., the pattern numbers of the first and second electrode sheets from the process controller 170. Further, the identification information management server 160 may issue a virtual ID to the corresponding electrode assembly EA. In this case, the identification information assigning device for the electrode assembly may be the identification information management server 160.

Alternatively, the combination of the process controller 170 and the identification information management server 160 may form the identification information assigning device.

The process controller 170 and/or the identification information management server 160, or the monitoring server 180 which will be described below may further associate the identification information with the coordinate data in addition to the cutting operation code, and the pattern identification data. For example, the coordinate values of the first electrode sheet supplied to the first cutter corresponding to the first length acquired by the first position measuring instruments 111N and 112N, in particular, at least one of a start coordinate value and an end coordinate value of the first length, and the coordinate values of the second electrode sheet supplied to the second cutter corresponding to the second length, in particular, at least one of the start coordinate value and the end coordinate value of the second length, acquired by the second position measuring instruments 111P and 112P may be associated with the cutting operation code, e.g., the cut count value, and the pattern identification data acquired at the same time as the coordinate value. Accordingly, the coordinate values may also be associated with the identification information of the electrode assembly.

Accordingly, the process controller 170 and/or the identification information management server 160, or the monitoring server 180 which will be described below may assign, for example, the identification information ID to the corresponding electrode assembly EA in association with or on the basis of the start coordinate value and the end coordinate value of the first length W1 of the first electrode sheet, and the start coordinate value and the end coordinate value of the second length W2 of the second electrode sheet.

In this way, when the ID of the electrode assembly EA is identified, the cutting operation code and the position data, which may include the pattern identification data and/ or the coordinate data, of the electrodes included in the corresponding electrode assembly are specified. Based on the cutting operation code and the position data, the manufacturing history of each sub-process before the winding process may be tracked. Further, the defect inspection, transfer, tray loading, and can storage processes of the electrode assembly may be performed based on the ID of the electrode assembly EA. Therefore, the manufacturing history may be easily tracked in the process after the winder 150 on the basis of the identification information of the electrode assembly EA.

Meanwhile, the process controller 170 and/or the identification information management server 160 may manage the identification information of the electrode assembly EA in association with the process event data of each electrode. For example, since the measurement data and/or the inspection data acquired by various types of measuring instrument and/or inspecting instrument in the process from the unwinder to the winder is associated with the position data (pattern identification data, coordinate data), the measurement data and/or the inspection data may be associated with the identification information of the electrode assembly associated with the position data through the position data.

The process controller 170 may controls each device provided in the winding process, and at the same time, may transmit data acquired from each device to the monitoring server 180. Further, the identification information management server 160 may transmit the identification information ID assigned to the electrode assembly EA to the monitoring server 180.

The process controller 170 may transmit, for example, the measurement data and/or the inspection data PNMD/PNID associated with the pattern identification data, the measurement data and/or the inspection data CMD/CND associated with the coordinate data, and the measurement data and/or the inspection data PNCMD/PNCND associated with the identification data and the coordinate data to the monitoring server 180, e.g., through the relay server such as EIF or the like. The monitoring server 180 may generate a first electrode roll map, which is a graphical representation simulating the electrode, including first position data (pattern identification data, coordinate data) of the first electrode sheet moving from the first electrode roll to the winder, and first process event data associated with the first position data.

Further, the monitoring server 180 may generate a second electrode roll map including second position data (pattern identification data, coordinate data) of the second electrode sheet moving from the second electrode roll to the winder, and second process event data associated with the second position data.

According to exemplary embodiments, the monitoring server 180 may be a data processing system for supporting all activities required to manage battery manufacturing, such as work schedule management, work instructions, quality control, and production result calculation. The monitoring server 180 may be, for example, a manufacturing execution system (MES). The monitoring server 180 may be configured to perform input, processing, output, and communication of data required for electrode manufacturing, such as coating process, press process, and manufacturing process.

For example, the monitoring server 180 may be configured to store and process raw measurement data. The monitoring server 180 may monitor the quality of processing of the electrode sheet by continuously monitoring the processing of the electrode sheet on the basis of the measurement data. For example, the monitoring server 180 may be a statistical process controller (SPC). The monitoring server 180 may identify problem conditions in a timely manner and provide alerts to operators before potential problems occur by collecting and analyzing manufacturing data in near real time.

Optionally, the monitoring server 180 may be, for example, a data warehouse and may store a roll map for a long period of time, e.g., over a quality warranty period of the product.

Further optionally, the monitoring server 180 may perform all the functions of the MES, the SPC, and the data warehouse, or may be provided separately from the MES, the SPC, and the data warehouse to generate a roll map.

Referring to FIG. 4, it is shown that a first electrode sheet ESN of a first length W1 and a second electrode sheet ESP of a second length W2 are wound with a separator of a third length W3 therebetween to form an electrode assembly EA.

For electrical safety and insulation when a jelly roll-shaped electrode assembly EA is used, the first to third lengths may be different from each another. For example, the length (third length W3) of the separator located between the first electrode sheet and the second electrode sheet may be greater than the length of the electrode sheets ESN, ESP. Besides, the separator may be additionally located on a radially outmost side of the jelly roll-shaped electrode assembly, and thus it is possible to prevent an electrical short circuit from occurring due to direct contact between the first and second electrode sheets. Further, for example, the length (first length W1) of the first electrode sheet, i.e., of the first electrode cut portion, which is a negative electrode, may be made greater than the length (second length W2) of the second electrode sheet, i.e., of the second electrode cut portion, which is a positive electrode.

Referring to FIG. 4, the first electrode sheet of the first length W1 includes a first electrode coated portion included a respective pattern, which, in the example of FIG. 4, is identified by the first pattern identification code in the form of the first pattern number ①. Uncoated portions are present on both sides of the first electrode coated portion. The length acquired by summing the first electrode coated portion and the uncoated portions on both sides is set as the first length W1. The first length W1 is stored in the process controller 170 and the first cutter 140N.

The second electrode sheet of the second length W2 ESP includes a second electrode coated portion included a respective pattern which, in the example of FIG. 4, is identified by the second pattern identification code in the form of the second pattern number ⓐ. Uncoated portions are present on both sides of the second electrode coated portion. The length acquired by summing the second electrode coated portion and the uncoated portion on both sides is set as the second length W2. The second length W2 is stored in the process controller 170 and the second cutter 140P. In this way, an electrode assembly EA may be manufactured by providing one first electrode coated portion and one second electrode coated portion (one pattern each) corresponding to the first length W1 and the second length W2, respectively.

Generally, the first and second lengths may be preset such that the first and second electrode cut portions formed by cutting, respectively include at least one coated portion having two uncoated portions positioned at both ends thereof, and such that a number of the coated portions provided on the first electrode cut portion and a number of the coated portion provided on the second electrode cut portion are identical.

A pattern number is not necessarily displayed only with Arabic numerals. When a sequence number can be displayed, the sequence number may also be displayed with the alphabet, other letters or symbols, or a combination of numbers and letters. Generally, a pattern identification code may be used for identifying the respective pattern.

FIG. 5 exemplarily shows a first electrode sheet of a first length including one first electrode coated portion included in one respective pattern which, in the example of FIG. 5, is identified by the first pattern identification code in the form of the first pattern number ①. In the example of FIG. 5, a second electrode sheet of a second length includes two second electrode coated portions included in two neighboring patterns which, in the example of FIG. 5 are identified by the second pattern identification codes in the form of second pattern numbers ⓐ and ⓑ, wherein and an uncoated portion is located between the two second electrode coated portions. That is, in this case, one pattern number on the first electrode cut portion corresponds to two pattern numbers on the second electrode cut portion. Since the second electrode coated portions having two patterns are are provided on the second electrode sheet as a half pattern, respectively, the overall length of the second electrode coated portion of the second electrode sheet may be approximately the same as that of pattern 1.

Generally, the first electrode sheet may be cut at an uncoated portion of the first electrode sheet, wherein the first length is preset such that the subsequently formed first electrode cut portion includes at least one coated portion having two uncoated portions positioned at both ends thereof. The second electrode sheet may be cut at a coated portion of the second electrode sheet, wherein the second length is preset such that the formed second electrode cut portion includes at least one uncoated portion having two coated portions positioned at both ends thereof. In this case, the first and second lengths may be further preset such that a number of coated portions provided on the second electrode cut portion is greater than a number of coated portions provided on the first electrode cut portion.

When the electrode assembly is manufactured by winding in the pattern arrangement as described above and as exemplarily illustrated in FIG.5, there is no uncoated portion on both ends of the second electrode coated portion. Therefore, the risk of a short circuit due to contact with the current collector (uncoated portion), which may occur when the separator interposed between the two electrode sheets is damaged, may be reduced.

Further, in terms of energy density, the electrode assembly EA wound in the form illustrated in FIG. 5 may be more advantageous.

FIG. 6 shows monitoring data generated by the monitoring server 180. The monitoring server 180 may generate the monitoring data by associating the identification information of the electrode assembly with one or more of the following:
1) the first pattern identification data, e.g., the first pattern number, of the first electrode sheet and the second pattern identification data, e.g., the second pattern number, of the second electrode sheet;
2) lot identification information of the first electrode sheet and lot identification information of the second electrode sheet;
3) the cutting operation code, e.g., the cut count value, of the first electrode sheet and the cutting operation code, e.g., the cut count value, of the second electrode sheet;
4) at least one of a start coordinate value and an end coordinate value of the first length and a start coordinate value and an end coordinate value of the second length;
5) data regarding defects of the first electrode sheet and the second electrode sheet or defects of the electrode assembly;
6) first process event data associated with the first position data and the second process event data associated with the second position data;
7) tray identification information of a tray on which the electrode assembly is loaded;
8) data regarding a loading position of the electrode assembly withinin the tray; and
9) can identification information of an electrode can in which the electrode assembly is accommodated.

The top of FIG. 6 shows roll maps of a first electrode sheet being a negative electrode sheet, and a second electrode sheets being a positive electrode sheet, each moving in the winding process, wherein the roll maps are generated by the monitoring server 180.

First pattern identification codes in the form of first pattern numbers ① to ⑩ are displayed on the roll map of the negative electrode (sheet), and coordinate values are displayed at predefined points. Optionally, consecutive coordinate values (roll map coordinate values) matched to time values in the longitudinal direction of the negative electrode sheet may be stored in the monitoring server 180. Therefore, as shown in the table at the bottom of FIG. 6, the monitoring server 180 may call detailed coordinate values corresponding to each pattern section, such as start and end coordinate values of each first or second length, or start and end coordinate values of each pattern, and perform matching or associating data with the coordinate values. On the roll map of the negative electrode (sheet), connection tape CT and appearance defects AD detected by the measuring instrument and/or inspecting instrument are also shown. The connecting tape CT may be detected by the seam sensor 131. The negative electrode sheet is not made of one lot, but of two lots VO1 and VO2 connected with the connecting tape CT. Therefore, when the connecting tape CT is detected, the coordinate value of the electrode sheet of the second lot VO2 is reset and starts again from 0.

Second pattern identification codes in the form of second pattern numbers ⓐ to ⓙ are displayed on the roll map of the positive electrode (sheet), and coordinate values are displayed at each major point. As shown in the table at the bottom of FIG. 6, the monitoring server 180 may call detailed coordinate values corresponding to each pattern section and perform matching or associating data with the coordinate values. On the roll map of the positive electrode (sheet), connection tape CT and appearance defects AD are also shown. The connecting tape CT may be detected by the seam sensor 132. The positive electrode sheet is made of two lots E23 and E24 connected with the connecting tape CT. Therefore, when the connecting tape CT is detected, the coordinate value of the electrode sheet of the second lot E24 is reset and starts again from 0.

As illustrated in FIG. 6, it can be seen that J1 is assigned as the ID of the jelly roll (J/R)-shaped electrode assembly manufactured from the electrode cut portions identified by the pattern numbers ① and ⓐ, the negative electrode cut count (Cut No) value of 696, and the positive electrode cut count value of 710. In this way, it can be seen that J1 to J12 are assigned as the ID of the electrode assembly and associated with the pattern number and the cut count value of each electrode cut portion. As described above, the process controller and the identification information management server may assign the IDs.

Since the lot identification information can be acquired, for example, when a respective electrode roll is loaded onto the corresponding unwinder, the lot identification information may be associated with the identification information of the electrode assembly EA.

Further, with respect to the ID of the electrode assembly, start and end point coordinates of the electrode (sheet) corresponding to each pattern number may also be associated with each other as shown in the table of FIG. 6.

Further, referring to the bottom of the table in FIG. 6, a tray ID on which an electrode assembly of a specific ID is loaded, and its loading position (row and column) are also displayed. Information about the tray ID and information about the loading position may also be transmitted to the monitoring server 180 so that the monitoring server 180 may also associate the information with the ID of the electrode assembly. Although not shown in FIG. 6, for example, when the identification information (can ID) is assigned to the electrode can in which the electrode assembly is accommodated, the can ID may also be associated with the identification information of the electrode assembly. The can ID may be assigned, for example, for each tray loading position shown in FIG. 6.

FIG. 6 shows data for the electrode assembly wound so that the negative electrode and the positive electrode each correspond to one pattern (number) (see FIG. 4). Therefore, one first pattern number and one second pattern number are associated with each other.

However, when the electrode assembly is manufactured in the form illustrated in FIG. 5, one first pattern number of the negative electrode is also possible to correspond to two or more second pattern numbers of the positive electrode, for example.

As shown in FIG. 6 in the roll map of the negative electrode sheet, the first process event data associated with the first position data (first pattern number, first coordinate data CD1) may be displayed in the roll map of the negative electrode. For example, the connecting tape CT and appearance defect AD displayed at a specific location are also types of process event data. In addition to defects, other measurement data and/or inspection data, such as loading amount and web thickness, may also be displayed on the roll map of the negative electrode.

Likewise, the second process event data associated with the second position data (second pattern number, second coordinate data) may be displayed in the roll map of the positive electrode.

Further, whether the measurement data and/or the inspection data acquired by the measuring instrument and/or inspecting instrument 130 indicate a defect may be determined, and result values of the determination may be acquired by the monitoring server 180 through the process controller 170. Depending on the type of the measuring instrument and/or inspecting instrument 130, the type of defect may be identified. Therefore, data regarding defects of the first electrode sheet and the second electrode sheet may be associated with the identification information of the electrode assembly EA.

Defects in the electrode sheets ESN and ESP may be identified by a defect tag or defect marking attached to an actual electrode in a sub-process (e.g., roll pressing process or slitting process) before the winding process. Alternatively, when the connecting tape connecting the broken portion is detected during the winding process, the portion of the electrode sheet provided with the connecting tape may be regarded as being defective. Alternatively, the portion determined to be defective by the measuring instrument and/or inspecting instrument within the winding process may be regarded as a defective electrode.

Meanwhile, when the electrode sheet ESN or ESP containing defects is wound with the separator sheet, it becomes a defective electrode assembly and is output or discharged into the defect storage port S2. In this case, even the wound normal electrode sheet and the separator sheet are wasted as well as the defective electrode sheet.

Therefore, when a defect is detected, e.g., by the measuring and/or inspecting instrument, on one of the first electrode sheet and the second electrode sheets, respectively within the first or second length to be supplied to the first or second cutter, the process controller may control the first cutter, the second cutter, and the winder to cut only the defective electrode sheet and wind and discharge the cut defective electrode sheet together with the separator as a defective electrode assembly.

For example, when the defective portion of an electrode sheet is supplied to the winder 150, the process controller 170 may generate a signal to control the unwinder, guide roll, or other driving mechanism to stop unwinding of electrode sheets that do not have defects. Accordingly, only the defective electrode sheet portion may be wound by the winder 150 without winding the normal electrode sheet. Electrode assemblies of the defective electrode sheet (see J3, J6, J8, and J10 in FIG. 6) may be discharged into the defect storage port S2.

In this case, identification information J3, J6, J8, and J10 of the defective electrode assemblies may be assigned to the defective electrode assembly and associated with the cutting operation code, e.g., the cut count value, of the defective electrode sheet and the pattern identification code, e.g., the pattern number, of the defective electrode sheet. That is, the ID of the defective electrode assembly is not related to the pattern identification data of the non-defective electrode sheet. In this case, when the cut counter of the cutter operating for the non-defective electrode sheet operates, i.e., operates without actually cutting an electrode sheet, the cut count value may be increased, and when the cut counter does not operate, the cut count value for non-defective electrode sheets may not be increased.

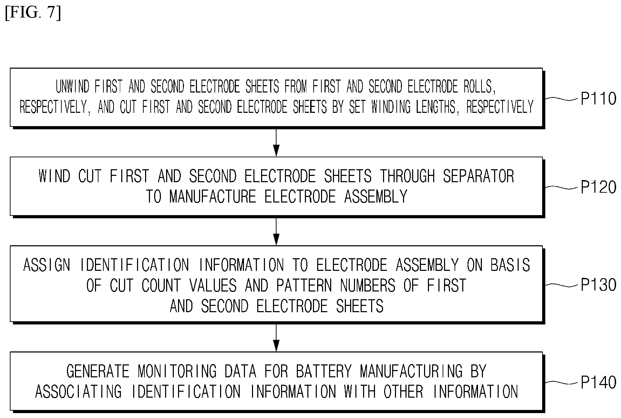

FIG. 7 is a flowchart of a method for manufacturing an electrode assembly for a battery.

Referring to FIGS. 3 to 7, the first electrode sheet ESN with patterns and the second electrode sheet ESP with patterns are unwound from the first electrode roll ERN and the second electrode roll ERP, respectively, and moved toward the winder 150. Further, the separator sheet is also unwound from the separator roll corresponding to each electrode roll and moved toward the winder 150.

The process controller 170 may control supply of the electrode sheets and the separator sheet to the cutters 140N, 140P and the winder 150 by operating the unwinder corresponding to each electrode roll and the separator roll.

The first electrode sheet ESN and the second electrode sheet ESP moving to the winder 150 may be inspected and measured using the predetermined measuring instrument and/or inspecting instrument. The measurement data and/or the inspection data acquired by the measuring instrument and/or inspecting instrument may be transmitted to the monitoring server 180 through the process controller 170. Each inspected and/or measured electrode sheet may be moved by a corresponding guide roll to join the separator sheet.

In step P 110 of the method, the first electrode sheet ESN may be supplied to the first cutter 140N, first position data reflecting positions on the first electrode sheet supplied to the first cutter may be acquired, e.g., by acquiring first pattern identification data and/or first coordinate data, and the first electrode sheet may be cut by the first cutter 140N by the first length W1. Hence, the first cutter is operated to cut the first electrode sheet to form a first electrode cut portion having a first length. Further, a first cutting operation code identifying the operation of the first cutter to form the respective first electrode cut portion is generated in step P110. This may, for example, include detecting a length of the first electrode sheet supplied to the first cutter, and increasing a first cut count value each time the first length of the first electrode sheet is supplied to the first cutter.

Further, in step P 110, the second electrode sheet ESP may be supplied to the second cutter 140P, second position data reflecting positions on the second electrode sheet supplied to the first cutter may be acquired, e.g., by acquiring second pattern identification data and/or second coordinate data, and the second electrode sheet may be cut by the second cutter 140P by the second length W2. Hence, the second cutter is operated to cut the second electrode sheet to form a second electrode cut portion having a first length. Further, a second cutting operation code identifying the operation of the second cutter to form the respective second electrode cut portion is generated in step P110. This may, for example, include detecting a length of the second electrode sheet supplied to the second cutter, and increasing a second cut count value each time the first length of the first electrode sheet is supplied to the first cutter.

In a next step P120, the first electrode cut portion of the first electrode sheet of the first length W1 and the second electrode cut portion of the second electrode sheet of the second length W2 may be wound with a separator therebetween by the winder 150 to form a jelly roll-shaped electrode assembly EA.. The winder 150 may include a separate cutter for cutting the separator sheet. In this case, the first electrode cut portion and the second electrode cut portion may be wound together with the separator of the third length W3 to manufacture the electrode assembly. Generally, step P120 includes manufacturing an electrode assembly by combining the first electrode cut portion and the second electrode cut portion with a separator interposed therebetween.

In step P130, identification information is to the manufactured electrode assembly. For example, the identification information may be physically marked on the electrode assembly. For example, a physical object may be formed on the electrode assembly, wherein the physical object contains the identification information assigned to the electrode assembly in a machine-readable form. Alternatively, a virtual ID may be assigned to the electrode assembly.

In step P140 the identification information assigned to the electrode assembly is associated with the first cutting operation code and first position data reflecting the positions on the electrode sheet corresponding to the first cut electrode portion, and with the second cutting operation code and second position data reflecting the positions on the electrode sheet corresponding to the second cut electrode portion.

The cutting operation codes may include cut count values which may be acquired by the cut counters provided in the cutters or the like, and the cut count values may be transmitted to the process controller 170, the identification information management server 160, or the monitoring server 180.

The position data may include pattern identification data including pattern identification codes, e.g., in the form of pattern numbers of the first and second electrode sheets which may be acquired by the first and second pattern counters. The acquired pattern numbers, or, generally, the pattern identification codes may be transmitted to the process controller 170, the identification information management server 160, or the monitoring server 180.

The identification information assigning device, which may be the process controller 170, the identification information management server 160, or a combination thereof, may assign, for example, virtual identification information ID to the completed electrode assembly EA on the basis of the cut count values and/or the pattern numbers.

Acquiring the first position data and the second position data may optionally include acquiring first coordinate data CD1 that can indicate positions of the first electrode sheet moving between the first electrode roll and the winder in succession, and second coordinate data that can indicate positions of the second electrode sheet moving between the second electrode roll and the winder in succession may be further included.

The first and second coordinate data may be associated with at least one of the following:
i) the identification information of the electrode assembly;
ii) the first and second cutting operation code; and
iii) the first pattern identification code and the second pattern identification code.

The first coordinate data may include at least one of a start coordinate value and an end coordinate value of the first length, and the second coordinate data CD2 may include at least one of a start coordinate value and an end coordinate value of the second length.

The identification information of the electrode assembly EA may be associated with one or more of the following by the monitoring server 180 in step P140:
1) the first pattern identification code of the first electrode cut portion and the second pattern identification code of the second electrode cut portion;
2) lot identification information of the first electrode cut portion and lot identification information of the second electrode cut portion;
3) the first and second cutting operation code;
4) at least one of the start coordinate value and the end coordinate value of the first length and the start coordinate value and the end coordinate value of the second length;
5) data regarding defects of the first electrode sheet and the second electrode sheet or defects of the electrode assembly;
6) the first process event data associated with the first position data and the second process event data associated with the second position data;
7) tray identification information of a tray on which the electrode assembly is loaded;
8) data regarding a loading position of the electrode assembly in the tray; and
9) can identification information of an electrode can in which the electrode assembly is accommodated.

Meanwhile, in order to save materials, when there is a defect in one of the first electrode sheet of the first length and the second electrode sheet of the second length, only the defective electrode sheet may be cut, and the cut defective electrode sheet may be wound together with the separator and discharged as a defective electrode assembly. Hence, the method may further include inspecting and/or measuring the first and second electrode sheets supplied to the first and second cutters to detect defects on each of the first and second electrode sheets, and, when a defect is detect on one of the first and the second electrode sheet, cutting only the electrode sheet on which the defect is detected, combining the cut defective electrode sheet with the separator, and discharging the combined electrode sheet and the separator as a defective electrode assembly. In this case, the identification information of the defective electrode assembly may be assigned to the defective electrode assembly and associated with the cutting operation code of the defective electrode sheet and the pattern identification code(s) of the defective electrode sheet.

According to the method described above, the quality of electrodes and an electrode assembly including the electrodes may be tracked not only within the winding process, but also between the winding process and processes before and after the winding process, through the identification information of the electrode assembly. Accordingly, the manufacturing reliability of processed products, semi-finished products, and products may be improved throughout the entire battery manufacturing process.

To manufacture an electrode assembly as exemplarily shown in FIG. 4, the first/second cutters may be operated in step P 110, using the acquired coordinate values, so that the first/second electrode sheets are initially cut at an uncoated portion of the first/second electrode sheets. In this case, the first/second lengths may be preset such that subsequently formed first/second electrode cut portions respectively include at least one coated portion having two uncoated portions positioned at both ends thereof, and further such that a number of the coated portion provided on the first electrode cut portion and a number of the coated portion provided on the second electrode cut portion are identical.

To manufacture an electrode assembly as exemplarily shown in FIG. 4, the first cutter may be operated in step P 110, using the acquired coordinate values, so that the first electrode sheet is initially cut at an uncoated portion of the first electrode sheet, wherein the first length is preset such that subsequently formed first electrode cut portions respectively include at least one coated portion having two uncoated portions positioned at both ends thereof. Similar, the second cutter may be operated in step P110, using the acquired coordinate values, so that the second electrode sheet is initially cut at a coated portion of the second electrode sheet, wherein the second length is preset such that each subsequently formed second electrode cut portions include at least one uncoated portion having two coated portions positioned at both ends thereof. Further, the first/second lengths are preset such that a number of coated portions provided on the second electrode cut portion is greater than a number of coated portions provided on the first electrode cut portion.

The present invention has been described above in more detail through the drawings and examples. However, since the embodiments described in this specification and configurations illustrated in drawings are only exemplary embodiments and do not represent the overall technological scope of the present invention, it is understood that the present invention covers various equivalents and modifications that are substitutable at the time of filing of this application.

### [List of reference signs]

10, 1000: battery manufacturing system
111N, 112N: first position measuring instrument
111P, 112P: second position measuring instrument
120N: first pattern counter
120P: second pattern counter
130: measuring instrument and/or inspecting instrument
140N: first cutter
140P: second cutter
150: winder
160: identification information management server
170: process controller
180: server

## Claims

1. A system for manufacturing an electrode assembly for a battery, comprising:
a first cutter configured to cut a first electrode sheet to form a first electrode cut portion having a first length, the first electrode sheet including a plurality of first coating patterns, each coating pattern having at least one coated and one uncoated portion;
a first sensor arrangement configured to generate a first cutting operation code identifying the operation of the first cutter to form a respective first electrode cut portion, and to acquire first position data reflecting positions on the first electrode sheet for forming the respective first electrode cut portion;
a second cutter configured to cut a second electrode sheet to form a second electrode cut portion having a second length, the second electrode sheet including a plurality of second coating patterns, each coating pattern having at least one coated and one uncoated portion;
a second sensor arrangement configured to generate a second cutting operation code identifying the operation of the first cutter to form a respective second electrode cut portion, and to acquire second position data reflecting positions on the second electrode sheet for forming the respective second electrode cut portion;
a combinator configured to manufacture an electrode assembly by combining the first electrode cut portion and the second electrode cut portion with a separator interposed therebetween; and
an identification information assigning device configured to assign identification information to the manufactured electrode assembly and associate the identification information with the first cutting operation code and the first position data reflecting the positions on the electrode sheet corresponding to the first cut electrode portion, and with the second cutting operation code and the second position data reflecting the positions on the electrode sheet corresponding to the second cut electrode portion.

2. The system of claim 1, wherein the combinator is a winder configured to wind the first electrode cut portion and the second electrode cut portion with the separator interposed therebetween to thereby manufacture the electrode assembly, and wherein the system further comprises a first electrode roll from which the first electrode sheet is supplied to the first cutter by unwinding, and a second electrode roll from which the second electrode sheet is supplied to the second cutter by unwinding.

3. The system of claim 1 or 2, wherein:
the first sensor arrangement includes at least one first position measuring instrument (111N, 112N) configured to detect a length of the first electrode sheet supplied to the first cutter (140N), and a first cut counter configured to increase a first cut count value each time the first length of the first electrode sheet is supplied to and cut by the first cutter, wherein the first cutting operation code includes the first cut count value(s); and
the second sensor arrangement includes at least one second position measuring instrument (111P, 112P) configured to detect a length of the second electrode sheet supplied to the second cutter (140P), and a second cut counter configured to increase a second cut count value each time the second length of the second electrode sheet is supplied to and cut by the second cutter, wherein the second cutting operation code includes the second cut count value(s).

4. The system of claim 3, wherein:
the first position measuring instrument is configured to acquire first coordinate data containing coordinate values that respectively indicate longitudinal positions on the first electrode sheet, wherein the first position data includes the first coordinate data; and
the second position measuring instrument is configured to acquire second coordinate data containing coordinate values that respectively indicate longitudinal positions on the second electrode sheet, wherein the second position data includes the second coordinate data.

5. The system of any one of the preceding claims, wherein:
the first sensor arrangement includes a first pattern counter (120N) configured to acquire a first pattern identification code of a coating pattern on the first electrode sheet supplied to the first cutter (140N), the first pattern identification code representing a respective one of the plurality of coating patterns by its position on the first electrode sheet, wherein the first position data includes the first pattern identification code; and
the second sensor arrangement includes a second pattern counter (120P) configured to acquire a second pattern identification code of a coating pattern on the second electrode sheet supplied to the second cutter (140P), the second pattern identification code representing a respective one of the plurality of coating patterns by its position on the second electrode sheet, wherein the second position data includes the second pattern identification code.

6. The system of any one of the preceding claims, further comprising:
a measuring and/or inspecting instrument (130) configured to detect defects on each of the first and second electrode sheets, wherein the identification information assigning device is configured to associate the identification information with the detected defect.

7. The system of any one of the preceding claims, further comprising:
a process controller (170) configured to control the first cutter (140N) to cut the first electrode sheet by the first length and to control the second cutter (140P) to cut the second electrode sheet by the second length.

8. The system of claim 7, insofar as being dependent upon claim 6, wherein the process controller is configured to, when a defect is detected by the measuring and/or inspecting instrument (130) on one of the first and second electrode sheets, respectively within the first or second length to be supplied to the first or second cutter, control the first cutter and the second cutter to cut only the defective one of the first and second electrode sheets and further control the combinator to combine the cut defective electrode sheet only with the separator and discharge the combined electrode sheet and the separator as a defective electrode assembly.

9. The system of any one of the preceding claims, wherein the identification information assigning device includes:
a process controller (170) that is configured to control at least some of multiple process facilities that physically interact with the electrode sheets, or
a separate identification information management server (160) communicatively connected to the process controller, or
a combination of the process controller (170) and the identification information management server (160).

10. The system of any one of the preceding claims, further comprising:
at least one first electrode measuring and/or inspecting instrument provided between a first electrode roll for supplying the first electrode sheet and the combinator, and
at least one second electrode measuring and/or inspecting instrument provided between a second electrode roll for supplying the second electrode sheet and the combinator.

11. The system of any one of the preceding claims, further comprising a monitoring server (180) configured to generate:
a first electrode roll map as a graphical representation of the first electrode sheet, the first electrode roll map including first position data of the first electrode sheet supplied to the combinator and first process event data associated with the first position data, the first process event data being data on the first electrode sheet acquired during processing of the first electrode sheet by the battery manufacturing system, and
a second electrode roll map as a graphical representation of the second electrode sheet, the second electrode roll map including second position data of the second electrode sheet supplied to the combinator and second process event data associated with the second position data, the second process event data being data on the second electrode sheet acquired during processing of the second electrode sheet by the battery manufacturing system.

12. The system of claim 11, wherein the monitoring server (180) is configured to associate the identification information of the electrode assembly with one or more of the following:
lot identification information of the first electrode sheet and lot identification information of the second electrode sheet;
data regarding defects of the first electrode sheet and the second electrode sheet or defects of the electrode assembly;
the first process event data associated with the first position data and the second process event data associated with the second position data;
tray identification information of a tray on which the electrode assembly is loaded;
data regarding a loading position of the electrode assembly within the tray; and
can identification information of an electrode can in which the electrode assembly is accommodated.

13. A method for manufacturing an electrode assembly for a battery, comprising:
supplying a first electrode sheet to a first cutter, the first electrode sheet including a plurality of first coating patterns, each first coating pattern having at least one coated and one uncoated portion;
acquiring first position data reflecting positions on the first electrode sheet supplied to the first cutter;
cutting, by operating the first cutter, the first electrode sheet to form a first electrode cut portion having a first length;
generating a first cutting operation code identifying the operation of the first cutter to form the respective first electrode cut portion;
supplying a second electrode sheet to a second cutter, the second electrode sheet including a plurality of second coating patterns, each second coating pattern having at least one coated and one uncoated portion;
acquiring second position data reflecting positions of the second electrode sheet supplied to the second cutter;
cutting, by operating the second cutter, the second electrode sheet to form a second electrode cut portion having a second length;
generating second cutting operation code identifying the operation of the second cutter to form the respective second electrode cut portion;
manufacturing an electrode assembly by combining the first electrode cut portion and the second electrode cut portion with a separator interposed therebetween;
assigning identification information to the manufactured electrode assembly; and
associating the identification information assigned to the electrode assembly with the first cutting operation code and first position data reflecting the positions on the electrode sheet corresponding to the first cut electrode portion, and with the second cutting operation code and second position data reflecting the positions on the electrode sheet corresponding to the second cut electrode portion.

14. The method of claim 13, wherein:
generating the first cutting operation code includes detecting a length of the first electrode sheet supplied to the first cutter, and increasing a first cut count value each time the first length of the first electrode sheet is supplied to the first cutter; and
generating the second cutting operation code includes detecting a length of the second electrode sheet supplied to the second cutter, and increasing a second cut count value each time the second length of the second electrode sheet is supplied to the second cutter.

15. The method of claim 13 or 14, wherein:
acquiring the first position data includes acquiring a first pattern identification code of a coating pattern on the first electrode sheet supplied to the first cutter (140N), each first pattern identification code representing a respective one of the plurality of coating patterns by its position on the first electrode sheet; and
acquiring the second position data includes acquiring a second pattern identification code of a coating pattern on the second electrode sheet supplied to the second cutter (140P), each second pattern identification code representing a respective one of the plurality of coating patterns by its position on the second electrode sheet.

16. The method of any one of claims 13 to 15, wherein:
acquiring the first position data includes acquiring first coordinate data containing coordinate values respectively indicating longitudinal positions on the first electrode sheet; and
acquiring the second position data includes acquiring second coordinate data containing coordinate values respectively indicating longitudinal positions on the second electrode sheet.

17. The method of claim 16, wherein:
the first coordinate data include a first start coordinate value representing one end of the first electrode cut portion and a first end coordinate value representing an opposite end of the first electrode cut portion, the length of the first electrode cut portion is determined as a difference of the first start and end coordinate values; and
the second coordinate data include a second start coordinate value representing one end of the second electrode cut portion and a second end coordinate value representing an opposite end of the second electrode cut portion, the length of the second electrode cut portion is determined as a difference of the second start and end coordinate values.

18. The method of any one of claims 13 to 17, wherein the first electrode sheet is supplied to the first cutter by being unwound from a first electrode roll and by being wound by a winder, and
the second electrode sheet is supplied to the second cutter by being unwound from a second electrode roll and by being wound by the winder.

19. The method of any one of claims 13 to 18, further comprising additionally associating the identification information of the electrode assembly with one or more of the following:
lot identification information of the first electrode sheet and lot identification information of the second electrode sheet;
data regarding defects of the first electrode sheet and the second electrode sheet or defects of the electrode assembly;
first process event data associated with the first position data and the second process event data associated with the second position data;
tray identification information of a tray on which the electrode assembly is loaded;
data regarding a loading position of the electrode assembly within the tray; and
can identification information of an electrode can in which the electrode assembly is accommodated.

20. The method of any one of claims 13 to 19, further comprising:
inspecting and/or measuring the first and second electrode sheets supplied to the first and second cutters to detect defects on each of the first and second electrode sheets, and
when a defect is detected on one of the first and the second electrode sheet:
cutting only the electrode sheet on which the defect is detected;
combining the cut defective electrode sheet with the separator; and
discharging the combined electrode sheet and the separator as a defective electrode assembly.

21. The method of any one of claims 13 to 20, wherein the separator is provided with or cut to a third length greater than the first/second lengths before being combined with the first and second electrode cut portions.

22. The method of any one of claims 16 to 21, insofar as dependent upon claim 16, further comprising:
operating the first/second cutters, using the acquired coordinate values, so that the first/second electrode sheets are initially cut at an uncoated portion of the first/second electrode sheets,
wherein the first/second lengths are preset such that subsequently formed first/second electrode cut portions respectively include at least one coated portion having two uncoated portions positioned at both ends thereof, and such that a number of the coated portion provided on the first electrode cut portion and a number of the coated portion provided on the second electrode cut portion are identical.

23. The method of any one of claims 16 to 21, insofar as dependent upon claim 16, further comprising:
operating the first cutter, using the acquired coordinate values, so that the first electrode sheet is initially cut at an uncoated portion of the first electrode sheet, wherein the first length is preset such that subsequently formed first electrode cut portions respectively include at least one coated portion having two uncoated portions positioned at both ends thereof, and
operating the second cutter, using the acquired coordinate values, so that the second electrode sheet is initially cut at a coated portion of the second electrode sheet, wherein the second length is preset such that each subsequently formed second electrode cut portions include at least one uncoated portion having two coated portions positioned at both ends thereof,
wherein the first/second lengths are further preset such that a number of coated portions provided on the second electrode cut portion is greater than a number of coated portions provided on the first electrode cut portion.

24. An electrode assembly manufactured by the method in accordance with claim 22 or 23.

25. The electrode assembly in accordance with claim 24, having a physical object formed thereon, wherein the physical object contains the identification information assigned to the electrode assembly in a machine-readable form.
